# EUROPEAN PATENT APPLICATION

(11) **EP 1 032 029 A1**
(43) Date of publication of application: **30.08.2000**
(21) Application number: 99830101.4
(22) Date of filing: 26.02.1999
(51) Int. Cl.: H01L 21/336, H01L 21/8247, H01L 21/033

(54) **Process for manufacturing semiconductor integrated electronic memory devices having a virtual ground cells matrix**

(71) Applicant: STMicroelectronics S.r.l., 20041 Agrate Brianza (Milano) (IT)
(72) Inventor: Cereda, Manlio Sergio, 23871 Lomagna (Lecco) (IT); Brambilla, Claudio, 20049 Concorezzo (Milano) (IT); Caprara, Paolo, 20162 Milano (IT)
(74) Representative: Botti, Mario

(57) **Abstract**

A process for manufacturing electronic semiconductor integrated memory devices having a virtual ground and comprising at least a matrix of floating gate memory cells (1), the matrix being formed on a semiconductor substrate (2) with a plurality of continuous bit lines (BL) extending across the substrate (2) as discrete parallel strips, comprising at least the following steps:
- growing an oxide layer (3) over the matrix region;
- depositing the semiconductor throughout with a stack structure which comprises a first conductor layer (4), first dielectric layer (5), and second conductor layer (6):
- depositing a second dielectric layer (7);
- defining floating gate regions (10) by photolithography using a mask of "POLY1 along a first direction", to thereby define, in said dielectric layer (7), a plurality of parallel strips (8) which delimit a first dimension of floating gate regions;
- etching away said dielectric layer (7) to define said plurality of parallel dielectric strips (8);
- photolithographing by means of a mask of "POLY1 along a second direction" to define a plurality of dielectric islands (9) in said plurality of parallel strips (8);
- etching away said dielectric layer (7) to define the plurality of islands (9);
- etching away said stack structure (4,5,6) and the thin gate oxide layer (3) to define gate regions (10) of the matrix cells using said oxide island (9).

## Description

### Field of the Invention

This invention relates to an improved process of manufacturing semiconductor integrated electronic memory devices with cells matrix having virtual ground.

Specifically, the invention relates to a process for manufacturing semiconductor integrated electronic memory devices having virtual ground and comprising at least one matrix of floating gate memory cells, the matrix being formed on a semiconductor substrate with a plurality of continuous bit lines extending across the substrate as discrete parallel strips.

The invention relates, particularly but not exclusively, to a process for manufacturing semiconductor integrated electronic memory devices with cells matrix having virtual ground, and throughout the following description, reference will be made to that technical field for convenience of illustration.

### Prior Art

As is well known, electronic semiconductor-integrated EPROM or Flash EPROM memory devices comprise a plurality of non-volatile memory cells organized in matrix form; that is, the cells are arranged therein into rows, or word lines, and columns, or bit lines.

Each non-volatile memory cell comprises a MOS transistor whose gate electrode, located above the channel region, is floating, i.e. has a high D.C. impedance to all the other terminals of the same cell and the circuit whereto the cell is incorporated.

The cell also has a second electrode, the control gate, which is driven by means of appropriate control voltages. The other transistor electrodes are, as usual, the drain and source terminals.

In recent years, considerable effort went to the development of memory devices with increased circuit density. This effort resulted in electrically programmable non-volatile memory matrices of the contactless type being developed which have a so-called "tablecloth" or crosspoint structure.

An example of matrices of this kind, and their manufacturing process, is described in European Patent No. 0 573 728 to this Applicant.

In matrices of this type, the matrix bit lines are formed in the substrate as continuous parallel diffusion strips.

These matrices comprise memory cells which comprise floating gate capacitive coupling MOS devices.

Conventionally, the process flow for manufacturing such matrices includes forming, on the semiconductor substrate, mutually parallel stack strips which comprise a first layer of gate oxide, first layer of polysilicon, second layer of interpoly oxide, and second layer of polysilicon.

An implantation step is then carried out to provide the bit lines, and after the deposition of a planarizing layer, the matrix word lines are formed.

In the prior art, the gate regions of the individual cells are then defined by self-aligned etching.

This first solution has several drawbacks in that the self-aligned etch step becomes the more critical, the smaller the cell size.

The underlying technical problem of this invention is to provide a process for defining memory cells, arranged into matrices of the crosspoint type, which has such structural and functional features as to avoid the need for a critical gate region defining step, thereby overcoming the limitations and drawbacks which still beset the memory cells of prior art crosspoint matrices.

### Summary of the Invention

The concept behind this invention is one of fully defining each gate region of the matrix cells by means of an oxide island, before the matrix bit lines are defined.

Based on the above concept, the technical problem is solved by a process as previously indicated and defined in the characterizing portion of Claim 1.

The features and advantages of a device according to the invention will become apparent from the following description of an embodiment thereof, given by way of non-limitative example with reference to the accompanying drawings.

### Brief Description of the Drawings

In the drawings:

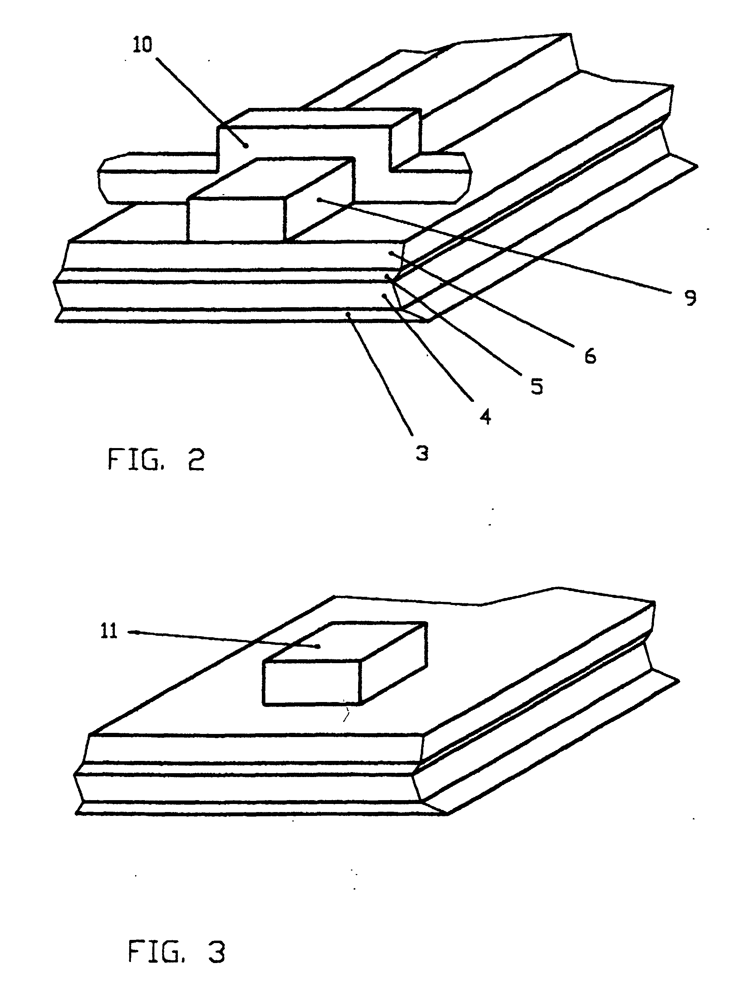

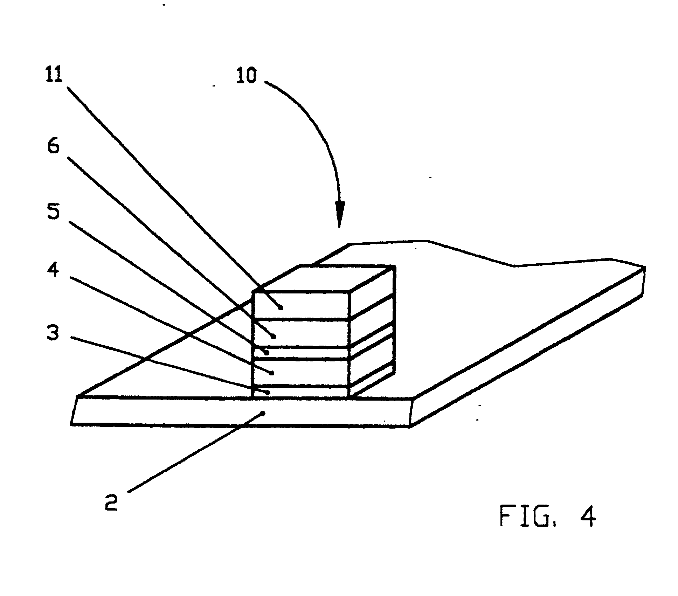

Figures 1 to 4 are perspective views showing schematically a portion of a semiconductor for forming virtual ground cell matrices in the evolution of a manufacturing process according to the invention;
Figure 5 is an enlarged perspective view showing schematically a portion of a semiconductor involved in a step of the inventive process;

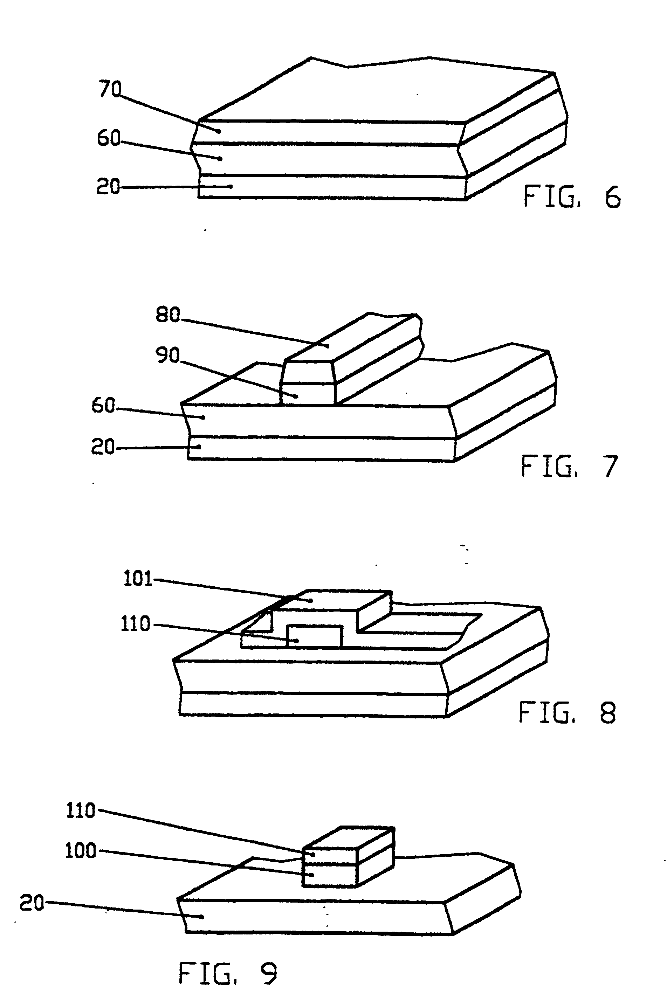

Figures 6 to 9 are perspective views showing schematically a portion of a semiconductor in the evolution of a manufacturing process according to the invention.

### Detailed Description

An improved process for manufacturing electronic memory devices integrated in a semiconductor substrate and comprising virtual ground cell matrices will be described with reference to the drawings.

The process steps discussed hereinafter do not form a complete process flow for manufacturing integrated circuits. The present invention can be used with the integrated circuit manufacturing techniques currently employed in the art, and of the process steps commonly used, only such as are necessary for an understanding of the invention will be discussed.

Those Figures which show in perspective portions of an integrated circuit during their manufacturing are not drawn to scale, but rather to highlight important features of the invention.

Accordingly, the description which follows will be limited to the definition of the memory cell matrix, without this being restrictive for the Applicant.

To form memory cells with floating gate capacitive coupling MOS devices on a conductor substrate 2, the process flow should provide for multiple deposition all over the semiconductor area in order to produce a stack structure comprising a first layer 3 of gate oxide, a first conductor layer 4 (also referred to as POLY1), a second interpoly dielectric layer 5, and a second conductor layer 6 (POLY CAP).

Typically, the material used for the conductor layers 4 and 6 would be polysilicon, and the intermediate dielectric layer could be ONO (Oxide-Nitride-Oxide), for example.

At this step of the process, the poly cap layer 6 can be doped.

A protective dielectric layer 7, e.g. a so-called top oxide, is deposited on top of the poly cap layer 6.

In accordance with the invention, the gate regions 10 of the matrix 1 are defined at this step of the manufacturing process.

A first mask 8 of a photo-sensitive material, such as a resist, referred to as a definition mask for the POLY1 along a first predetermined direction, is used to define the protective oxide layer 7 along said first direction.

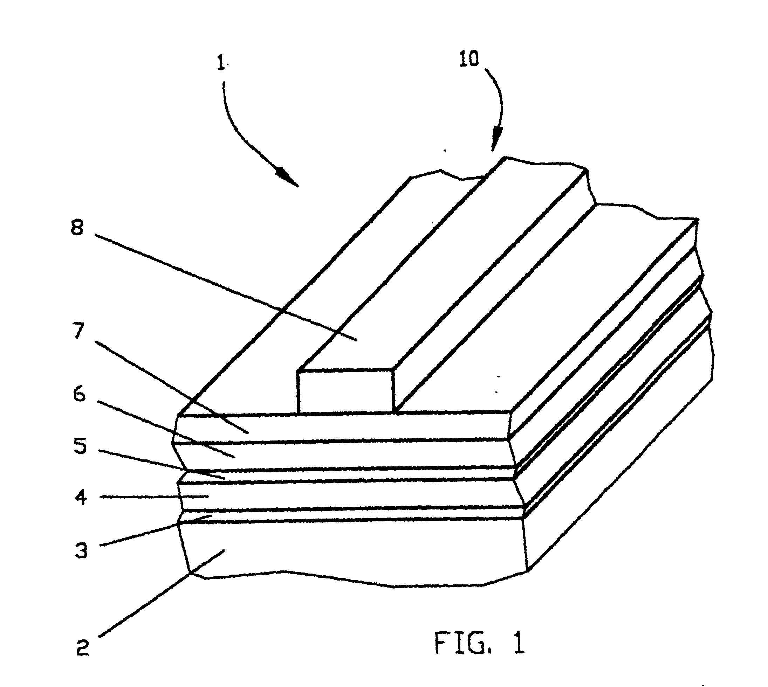

Figure 1 is a perspective view of the stack structure provided by this sequence of steps.

The protective oxide layer 7 is etched away by a conventional photolithographic step.

After removal of the first resist mask 8, the protective layer 7 appears as a plurality of parallel protective strips 9 which extend along the first direction and overlie the second polysilicon layer.

A second mask 10 of a photo-sensitive material, such as a photoresist, referred to as a definition mask for the POLY1 along a second predetermined direction, is used to define the protective strips 9 along said second direction.

The second direction lies substantially orthogonal to the first direction.

The protective strips 9 are etched further away by a conventional photolithographic step.

At this point, the protective layer 7 appears as formed of a plurality of islands 11 overlying the second polysilicon layer.

Using a conventional photolithographic step, the unprotected stack structure by the protective islands is then etched away in cascade to remove the second conductor layer 6, intermediate dielectric layer 5, first conductor layer 4 and gate oxide, in that order, and expose the substrate 2.

The gate regions 10 of the cells in the matrix 1 are now completed.

If desired, the resultant gate regions 10 may be sealed by an oxidation step.

Advantageously, spacers are formed on the side walls of the gate regions 10.

Advantageously, the first mask 8 of resist is used to define the bit lines of the matrix 1.

A first arsenic ion implantation, as necessary to provide N+ electric conductivity, allows bit lines BL of the virtual ground matrix 1 to be defined.

At this point, at least one dielectric layer 12 is conventionally deposited to planarize the semiconductor substrate surface by filling the gaps between gate regions 10.

The dielectric layer 12 is subjected to unmasked etching for exposing the poly cap 6 surface and removing the islands 11.

In this way, the second dielectric layer 12 is confined to just the interstitial regions between gate regions 10.

At this point, a multiple deposition can be carried out which comprises a conductor layer 13 and an optional final conductor layer 14, followed by an etching step using a conventional photolithography step for parallel strips having different widths and being oriented in an orthogonal direction to that of the bit lines, such as the matrix word lines.

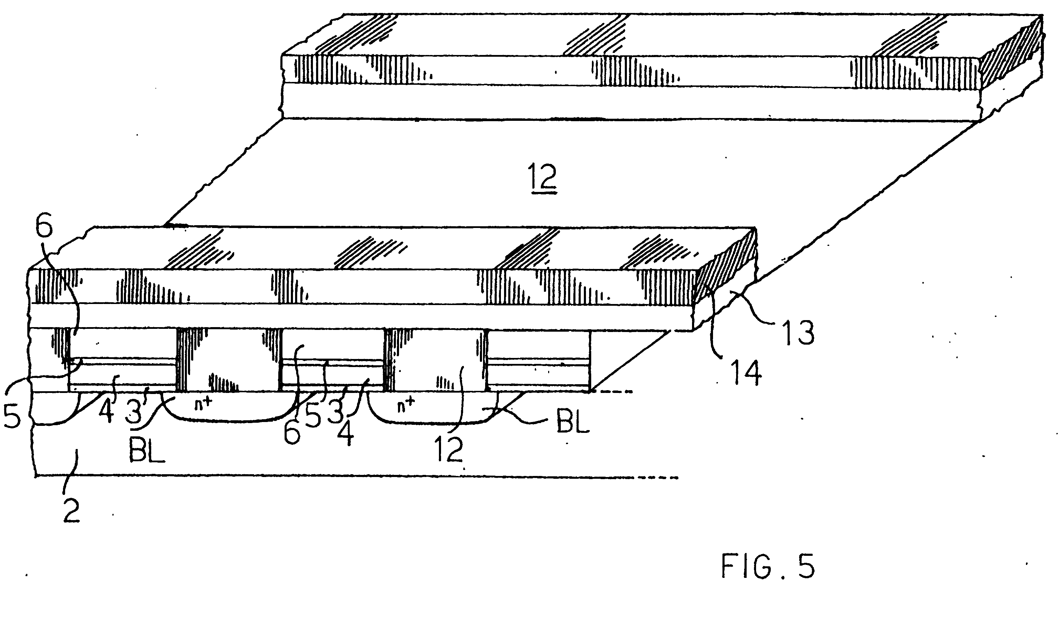

These strips are best shown in Figure 5, which is a schematic perspective view of the structure formed by the process steps carried out thus far.

To summarize, the process of the invention allows the gate regions of the matrix cells to be defined using an oxide island as a mask and for protection of the underlying layers.

In this way, the definition of the gate regions of the memory cell matrix is greatly improved over a manufacturing process which employs a single photolithographic definition step.

Furthermore, in comparison to the prior art, the self-aligned etching step for defining the matrix gate regions is avoided, this step becoming a fairly critical one with decreasing geometric dimensions of the cell.

The previous description is given with reference to the technical field of virtual ground memories, but the process can be used to provide semiconductor portions whose shape includes sharp corner edges.

According to the invention, a semiconductor substrate 2 is deposited a stack structure comprising a first layer, such as polysilicon 3, a second protective layer of a different material from the first layer, such as a dielectric layer.

Advantageously, the stack structure may include additional layers.

The first layer may vary in nature and material, and may be either a dielectric, nitride, or conductor layer.

At this step of the manufacturing process according to the invention, regions of the stack structure are defined.

A first mask 8 of a photo-sensitive material, e.g. of resist, referred to as a mask for defining the POLY1 along a first predetermined direction, is used to define the protective layer 7 along said first direction.

The protective layer 7 is etched away using a conventional photolithographic step.

After removing the first mask 8 of resist, the protective layer 7 appears as a plurality of parallel protective strips 9 extending in the first direction and overlying the first layer.

A second mask 10 of photo-sensitive material, such as a photoresist, referred to as a mask for defining the POLY1 along a second predetermined direction, is used to define the protective strips 9 along said second direction.

The second direction is substantially orthogonal to the first direction.

The protective strips 9 are subjected to further etching by a conventional photolithographic step.

At this point, the protective layer 7 appears as formed by a plurality of islands 11 overlying the first layer.

The unprotected stack structure by the protective islands is etched away using a conventional photolithographic step to remove the first layer and expose the substrate 2.

Thus, the regions are now formed with sharp corner edges.

Regions with sharp corner edges lying in plural predetermined directions can be provided using plural masking levels.

## Claims

1. A process for manufacturing electronic semiconductor integrated memory devices having a virtual ground and comprising at least a matrix of floating gate memory cells (1), the matrix being formed on a semiconductor substrate (2) with a plurality of continuous bit lines (BL) extending across the substrate (2) as discrete parallel strips, comprising at least the following steps:
- growing an oxide layer (3) over the matrix region;
- depositing the semiconductor throughout with a stack structure which comprises a first conductor layer (4), first dielectric layer (5), and second conductor layer (6), characterized in that it comprises the following additional steps:
- depositing a second dielectric layer (7);
- defining floating gate regions (10) by photolithography using a mask of "POLY1 along a first direction", to thereby define, in said dielectric layer (7), a plurality of parallel strips (8) which delimit a first dimension of floating gate regions;
- etching away said dielectric layer (7) to define said plurality of parallel dielectric strips (8);
- photolithographing by means of a mask of "POLY1 along a second direction" to define a plurality of dielectric islands (9) in said plurality of parallel strips (8);
- etching away said dielectric layer (7) to define the plurality of islands (9);
- etching away said stack structure (4,5,6) and the thin gate oxide layer (3) to define gate regions (10) of the matrix cells using said oxide island (9).

2. A process according to Claim 1, characterized in that said second direction is substantially orthogonal to the first direction.

3. A process according to Claim 2, characterized in that said first direction is the same as the direction of the bit lines (BL) .

4. A process according to Claim 3, characterized in that it comprises the following additional steps:
- forming spacers on the sidewalls of the gate regions;
- implanting to confer a predetermined conductivity on the bit line (BL) regions;
- filling with dielectric (12) and planarizing the gaps between gate regions 10.

5. A process according to Claim 4, characterized in that the mask of "Polyl along a first direction" is used for implanting the bit line (BL) regions of the matrix.

6. A process according to any of the preceding claims, characterized in that said dielectric layer (7) is an oxide layer.

7. A process for manufacturing portions of device regions formed on a semiconductor substrate, comprising the following steps:
- forming a stack structure on the semiconductor substrate including at least a first layer to be defined and a second protective layer;
- defining regions of the first material by photolithography using a first mask of "definition along a first direction", to thereby define in said protective layer a plurality of parallel strips (8) which delimit a first dimension of regions to be formed;
- etching away said protective layer (7) to define said plurality of parallel strips (8);
- photolithographing using a mask of "definition along a second direction" to define a plurality of islands (9) in said plurality of parallel strips (8);
- etching away said dielectric layer (7) to define the plurality of islands (9);
- etching away said first layer to define regions using said island (9) as a mask.
